# FASCICULE DE BREVET EUROPEEN

(11) **EP 2 575 258 B1**
(45) Date de publication et mention de la délivrance du brevet: **13.08.2014**
(21) Numéro de dépôt: 12186574.5
(22) Date de dépôt: 28.09.2012
(51) Int. Cl.: H04J 3/06, H03L 7/00

(54) **Dispositif à oscillateur, système de communication et procédés de contrôle associés**
Oszillatorvorrichtung, Kommunikationssystem und entsprechende Kontrollverfahren
Oscillator device, associated communication system and control methods

(30) Priorité: 28.09.2011 FR 1158687
(43) Date de publication de la demande: 03.04.2013
(73) Titulaire: Sagemcom Broadband SAS, 92500 Rueil Malmaison (FR)
(72) Inventeur: Donnenwirth, Freddy, 92500 Rueil Malmaison (FR)
(74) Mandataire: Regimbeau

(56) Documents cités:
- WO-A2-2010/052683
- US-A1- 2003 152 177
- US-B1- 7 103 072

## Description

### DOMAINE TECHNIQUE GENERAL

L'invention concerne un dispositif à oscillateur et un système de communication comprenant un tel dispositif. L'invention concerne également des procédés de contrôle d'un oscillateur et d'un système de communication.

### ETAT DE L'ART

Les oscillateurs, notamment à quartz, sont des oscillateurs électriques qui possèdent comme propriété utile d'osciller à une fréquence stable lorsqu'ils sont stimulés électriquement.

On connaît par exemple des oscillateurs contrôlés en tension (*Voltage controlled oscillator,* VCO), qui génèrent un signal dont la fréquence varie proportionnellement à la tension d'entrée appliquée à l'oscillateur.

Ces oscillateurs sont utilisés dans de nombreux systèmes électroniques de communication, pour obtenir des fréquences d'oscillation précises.

En particulier, ces oscillateurs sont utilisés dans les systèmes de communication dits « *femtocells* » ou « *femtocell* » (il s'agit de l'expression anglo-saxonne consacrée et utilisée par l'homme du métier, contraction des termes « femto » et « cellules »), qui constituent un élément de base du système cellulaire de système de téléphonie mobile de faible puissance, prévu pour offrir une couverture radio limitée et souvent dédiée pour un usage résidentiel ou en entreprise. Le terme *femtocell* est utilisé en raison de la petite taille de ces cellules de communication.

Les femtocells se connectent au réseau de l'opérateur de téléphonie mobile via une connexion Internet haut débit (par un routeur câble, ADSL, etc.). Elles jouent donc le rôle de passerelle entre le téléphone mobile de l'abonné de l'opérateur de téléphonie mobile et le réseau de téléphonie mobile.

Or, les femtocells doivent respecter des contraintes très précises en terme de fréquence d'émission.

A cet effet, les femtocells incorporent des oscillateurs, contrôlés en tension, chargés de fournir une fréquence d'horloge la plus stable possible.

Or, les oscillateurs subissent eux-mêmes une dérive dans leur stabilité. Cette dérive résulte de trois facteurs : la variation en température ambiante, les variations en alimentation électrique, et le vieillissement de l'oscillateur.

La variation en température est le facteur de dérive le plus important.

Il existe des dispositifs à oscillateur permettant de réduire ces dérives.

Toutefois, ceux-ci présentent un certain nombre d'inconvénients.

Certains d'entre eux incluent des oscillateurs présentant une stabilité accrue, mais dont les coûts de fabrication, et donc de vente, sont élevés.

Certains incluent des systèmes de compensation en température performants, mais qui sont coûteux et qui sont le plus souvent limités à des gammes de température ambiante existant en intérieur (habitations, entreprises), et non pas en extérieur.

D'autres incluent des systèmes de régulation en température consommant une quantité élevée d'électricité, ce qui est prohibitif pour certaines applications, comme les applications grand public.

Par conséquent, aucune des solutions connues de l'art antérieur n'est pleinement satisfaisante.

La publication de demande de brevet US 2003/0152177 A1 décrit un procédé et un système de correction de la dérive de fréquence de référence qui utilise des horodatages reçus d'une horloge de référence d'un réseau de communication pour régler un oscillateur local à cristal d'un dispositif de communication.

### PRESENTATION DE L'INVENTION

Dans un mode de réalisation, il est proposé un dispositif à oscillateur comprenant :
- un oscillateur, pour la génération d'une fréquence d'horloge,
- des moyens de chauffage de l'oscillateur,
- un processeur,
ledit dispositif étant **caractérisé en ce que** le processeur est adapté pour contrôler les moyens de chauffage de sorte que les moyens de chauffage imposent une température de régulation à l'oscillateur, ladite température de régulation étant fonction de la température ambiante.

Dans un mode de réalisation, le processeur fait varier la température de régulation en fonction de la température ambiante, la température de régulation variant de sorte à réduire l'écart entre la température ambiante et la température de régulation, permettant ainsi de réduire la consommation en énergie du dispositif à oscillateur.

Dans un mode de réalisation, le processeur est programmé pour stocker une pluralité de plages de valeurs de température ambiante, à chaque plage de valeur étant associée une valeur de température de régulation.

Dans un mode de réalisation, le processeur:
- détermine une plage de température ambiante initiale, fonction de la température ambiante mesurée initialement,
- décale les deux bornes de cette plage de température pour réduire l'écart entre la température ambiante (mesurée actuellement) et le centre de cette plage, la température de régulation étant fonction de cette plage de température, et
- recalcule cette plage lorsque la température ambiante atteint une borne de cette plage de température.

Dans un mode de réalisation, la fréquence d'horloge de l'oscillateur présente une dérive supérieure à 200 ppb pour une température ambiante comprise entre 0 et 70°C, et une dérive inférieure à 200 ppb pour une variation de 2°C de la température de régulation.

Selon un mode de réalisation, il est décrit un système de communication comprenant un tel dispositif à oscillateur, un module de communication radio, dont un signal horloge de référence est généré sur la base de la fréquence d'horloge générée par l'oscillateur, et des moyens de synchronisation, pour synchroniser la fréquence d'horloge de l'oscillateur avec au moins une source de référence distante, à travers un réseau de communication, ladite source fournissant une fréquence de référence.

Le système de communication peut également comprendre des moyens de connexion à un réseau Internet, pour réaliser une femtocell.

Dans un mode de réalisation, les moyens de synchronisation synchronisent la fréquence d'horloge de l'oscillateur avec une fréquence de référence fournie par au moins une source de référence distante, au travers d'un réseau de communication, ladite synchronisation étant réalisée à une fréquence de synchronisation, ladite fréquence de synchronisation étant variable en fonction des variations de la température de régulation.

Dans un mode de réalisation, les moyens de synchronisation synchronisent la fréquence d'horloge de l'oscillateur avec au moins une source de référence distante, lorsque la température de régulation est modifiée par le processeur, ou dès lors qu'ils reçoivent une information indiquant que le processeur est prêt à modifier la température de régulation, cette synchronisation étant réalisée à une fréquence de synchronisation fonction de la dérive entre la fréquence d'horloge de l'oscillateur et la fréquence de référence de la source de référence distante.

La solution proposée est peu coûteuse. En particulier, elle permet de disposer d'un système de communication présentant de bonnes performances en stabilité, tout en utilisant un oscillateur peu coûteux. Ces oscillateurs présentent une stabilité en fréquence plus faible que des oscillateurs plus coûteux disponibles sur le marché, mais peuvent être malgré tout utilisés grâce à la solution proposée, ce qui permet de réduire le coût de fabrication du système de communication.

En outre, la solution décrite permet de réduire la consommation électrique nécessaire à la régulation en température de l'oscillateur, et ce notamment à température ambiante basse ou moyenne.

Une réduction de la taille et de la puissance des moyens électriques alimentant un système de communication équipé d'un oscillateur est également possible.

Enfin, de bonnes performances en termes de stabilité et précision de la fréquence d'horloge de l'oscillateur sont conservées, malgré la réduction de la consommation électrique.

### PRESENTATION DES FIGURES

D'autres caractéristiques, buts et avantages de l'invention ressortiront de la description qui suit, qui est purement illustrative et non limitative, et qui doit être lue en regard des dessins annexés sur lesquels :
- la Figure 1 est une représentation schématique d'un mode de réalisation d'un dispositif à oscillateur ;
- la Figure 2 est une représentation d'étapes d'un mode de réalisation d'un procédé de contrôle de température dans un dispositif à oscillateur ;
- la Figure 3 est un exemple de valeurs de températures de régulation dépendante de la température ambiante;
- la Figure 4 est une représentation d'étapes d'un autre mode de réalisation d'un procédé de contrôle de température dans un dispositif à oscillateur ;
- la Figure 5 est une représentation schématique d'un mode de réalisation d'un système de communication comprenant un dispositif à oscillateur ;
- la Figure 6 est une représentation d'étapes d'un mode de réalisation d'un procédé de contrôle d'un oscillateur dans un système de communication ;
- la Figure 7 est une représentation d'étapes d'un autre mode de réalisation d'un procédé de contrôle d'un oscillateur dans un système de communication.

### DESCRIPTION DETAILLEE

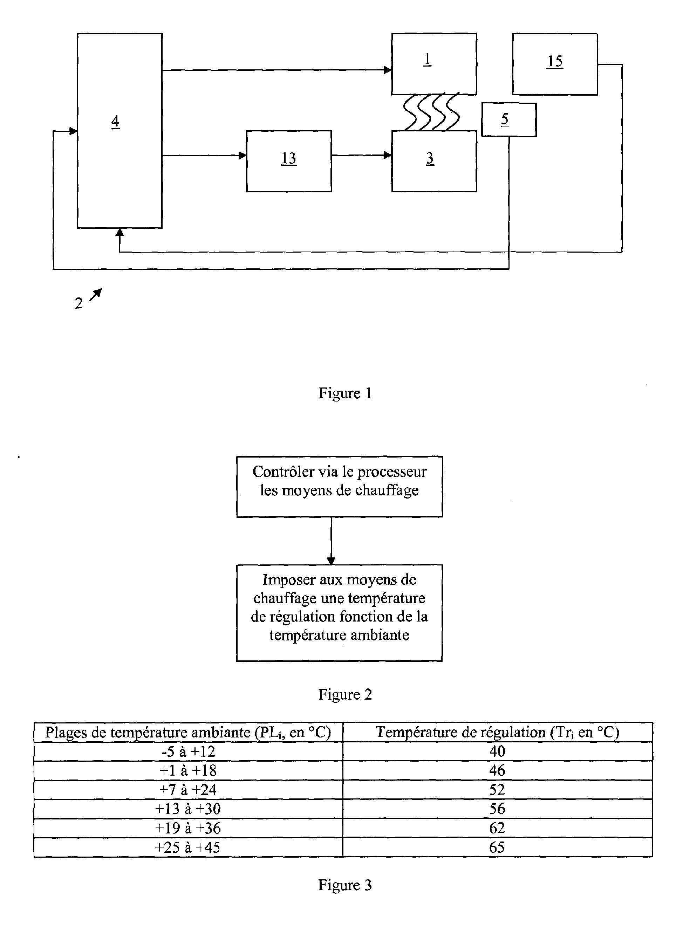

On a représenté en Figure 1 un dispositif 2 à oscillateur selon un mode de réalisation de l'invention. Comme explicité par la suite, ce dispositif 2 peut notamment être utilisé dans un système de communication, par exemple, mais non limitativement, de type femtocell.

Le dispositif 2 comprend un oscillateur 1, pour la génération d'une fréquence d'horloge.

L'oscillateur est par exemple un oscillateur à quartz, qui est un composant qui possède comme propriété utile d'osciller à une fréquence stable lorsqu'il est stimulé électriquement, via ses propriétés piézoélectriques. On parle en général d'oscillateur électronique.

Comme le sait l'homme du métier, le cristal de quartz a la forme d'un prisme. C'est en taillant les faces du cristal que l'on définit sa fréquence d'oscillation. Le cristal est monté entre deux électrodes métalliques dans un boîtier fermé hermétiquement.

Les oscillateurs à céramique peuvent remplacer les oscillateurs à quartz.

En général, la stimulation électrique de l'oscillateur est une stimulation en tension. On parle alors d'oscillateur contrôlé en tension (*VCO ou VCXO,* pour *Voltage Controlled Oscillator*).

Le VCO est un oscillateur qui change de fréquence proportionnellement à une tension qu'on lui applique. Un autre terme donné à ce phénomène est Modulation de Fréquence, ou FM (*Frequency Modulation*). La modulation de fréquence est réalisée en imposant une tension à un modulateur qui fait bouger ou dévier la fréquence de sa fréquence nominale. Cette commande, ou modulation de fréquence, peut être un courant continu, une onde sinusoïdale, une onde carrée ou une onde plus complexe.

Comme on le comprend, les conditions réelles de température, d'humidité, de pression et de vibration vont influencer la fréquence de résonance des oscillateurs, et par conséquent, la stabilité de leur génération en fréquence.

La température est le facteur le plus critique quant à la stabilité de l'oscillateur.

Le dispositif 2 comprend en outre des moyens 3 de chauffage de l'oscillateur 1. Dans un mode de réalisation, non limitatif, ces moyens 3 comprennent une ou plusieurs résistantes chauffantes, alimentées électriquement par un courant électrique de chauffage 13. Dans un autre mode de réalisation, ces moyens comprennent des résistances chauffantes et au moins un transistor, par exemple de type MOSFET (*Metal Oxide Semiconductor Field Effect Transistor*), qui pilote ces résistances. Le transistor joue notamment le rôle de résistance variable. Toutefois, le transistor peut également, en opération, participer au chauffage.

Le dispositif 2 comprend un processeur 4. Le terme processeur est à prendre au sens large, et inclut toute unité de traitement adapté pour l'exécution d'étapes d'un programme de commande. En général, le processeur 4 comprend une mémoire pour stocker un ou plusieurs programmes, qui comprennent eux-mêmes des instructions destinées à commander le processeur 4.

Afin d'améliorer la stabilité et la précision de la fréquence d'oscillation de l'oscillateur, le processeur 4 est adapté pour contrôler les moyens 3 de chauffage de sorte que les moyens 3 de chauffage imposent une température de régulation à l'oscillateur 1. Dans ce mode de réalisation, la température de régulation est fonction de la température ambiante.

Le processeur communique avec les moyens de chauffage par tout moyen adapté, comme par exemple via une communication filaire, ou sans fil, ou autre.

On entend par température ambiante la température extérieure, c'est-à-dire la température de la pièce ou de la zone dans laquelle l'oscillateur, et donc le dispositif à oscillateur, se trouve.

Ainsi, au lieu d'utiliser une température de régulation constante, celle-ci dépend des conditions extérieures dans lequel l'oscillateur est plongé, c'est-à-dire de la température ambiante.

Le fait d'asservir la température de régulation à la température ambiante permet de réduire l'écart entre la température ambiante et la température de régulation. En particulier, l'écart maximal entre la température ambiante et la température de régulation est alors réduit. Les variations de la température de régulation, vont, grâce au processeur, dans le sens des variations de la température ambiante, afin de réduire l'écart entre la température de régulation et la température ambiante. Ainsi, la température de régulation varie dans le sens d'une réduction de l'écart entre la température ambiante et la température de régulation, ce qui permet de réduire la consommation en énergie du dispositif à oscillateur.

Par conséquent, les moyens de chauffage sont moins sollicités, ce qui réduit la consommation en énergie du dispositif à oscillateur, sans nuire à la stabilité de génération en fréquence.

Le fait d'utiliser une température de régulation constante de valeur supérieure à toutes les valeurs courantes de température ambiante, a pour conséquence, a contrario, d'entraîner une consommation importante, en particulier aux basses températures.

Les étapes d'un mode de réalisation d'un procédé de contrôle d'un oscillateur sont illustrées en Figure 2. Le procédé comprend l'étape consistant à contrôler, via le processeur 4, les moyens 3 de chauffage, de sorte que les moyens 3 de chauffage imposent une température de régulation à l'oscillateur 1. La température de régulation est fonction de la température ambiante.

Dans un mode de réalisation, le processeur 4 est programmé pour stocker, dans une mémoire, une pluralité de plages (PLᵢ) de valeurs de température ambiante, à chaque plage de valeur étant associée une valeur de température de régulation.

En Figure 3, des exemples de valeurs non limitatives sont fournies.

Ainsi, lorsque la température ambiante est située entre -5°C et +12°C, le processeur fixe la température de régulation à 40°C

Les valeurs fournies en Figure 2 conviennent par exemple au cas d'une femtocell comprenant le dispositif à oscillateur, et située chez des particuliers.

Quand la température ambiante est en limite haute d'une plage PLᵢ, le processeur 4 augmente la température de régulation, le dispositif fonctionne alors dans une plage de température supérieure PLᵢ₊₁.

Quand la température ambiante est en limite basse d'une plage de température PLᵢ, le processeur 4 diminue la température de régulation, le dispositif fonctionne alors dans une plage de température inférieure PLᵢ₋₁.

Ainsi, le processeur fait varier la température de régulation en fonction de la température ambiante, dans le sens d'une réduction de l'écart entre la température ambiante et la température de régulation, afin de réduire la consommation en énergie du dispositif à oscillateur (en particulier des moyens de chauffage et du processeur).

Dans un mode de réalisation, le contrôle de la température de régulation est réalisé de la manière suivante.

Une largeur de plage de température ambiante LP est définie (par exemple 17°C).

En outre, un écart température EP entre la limite haute de la plage de température ambiante et la température de régulation est définie (par exemple 28°C).

Lors de l'allumage du dispositif 2, la température ambiante (Ta) est mesurée.

Le processeur 4 calcule la plage de température ambiante pour avoir la température ambiante au centre de cette plage. Ainsi, la limite supérieure de la plage de température est fixée comme égale à Ta + (LP/2), tandis que la limite inférieure est fixée comme égale à Ta - (LP/2).

Le processeur 4 calcule alors la température de régulation Trᵢ pour avoir un écart EP avec la limite supérieure de la plage de température. Ainsi, on obtient la température de régulation Trᵢ égale à « Limite supérieure de la plage de température + EP », c'est-à-dire Ta + (LP/2) + EP.

Lorsque la température ambiante est dans la plage de température ambiante, le processeur décale les deux bornes de la plage de température ambiante et la température de régulation Trᵢ en vue de réduire l'écart entre la température ambiante mesurée et le centre de la plage de température. Ce décalage de la température de régulation Trᵢ, doit se faire à une vitesse lente (par exemple 0.5°C/heure), pour avoir des variations de la fréquence d'horloge très faibles, et ainsi minimiser des accès à une source 10 de référence distante, configurée pour fournir une fréquence de référence à travers un réseau de communication, comme explicité par la suite.

Ce procédé permet de réduire les changements de température de régulation rapides quand la température ambiante arrive en limite de plage de température. Par conséquent, dans le mode de réalisation, décrit ultérieurement, d'un système de communication comprenant le dispositif 2 à oscillateur et des moyens de synchronisation, ce procédé permet de réduire la fréquence à laquelle les moyens de synchronisation synchronisent la fréquence d'horloge de l'oscillateur avec une fréquence de référence fournie par au moins une source de référence distante, à travers un réseau de communication,

Lorsque la température ambiante Ta arrive en limite de plage de température, la plage de température est changée :
- la nouvelle plage de température est recalculée, avec la limite haute de la nouvelle plage étant égale à Ta + LP/2 avec une largeur de plage LP (la nouvelle plage de température peut par exemple aussi être prise dans une liste de tables de température stockées dans une mémoire du processeur), et
- la température de régulation est modifiée (Trᵢ = Limite haute de la nouvelle plage de température + EP).

En cas de changement de plage de température, le changement de la température de régulation est opéré avec une vitesse supérieure à la vitesse de la variation maximale de la température ambiante (par exemple 0,5°C/mn).

En résumé, le processeur 4:
- détermine une plage de température ambiante initiale, fonction de la température ambiante mesurée initialement,
- décale les deux bornes de cette plage de température pour réduire l'écart entre la température ambiante et le centre de cette plage, la température de régulation étant fonction de cette plage de température, et
- recalcule cette plage lorsque la température ambiante atteint une borne de cette plage de température.

Ce mode de réalisation permet également de réduire l'écart entre la température ambiante et la température de régulation, pour réduire la consommation en énergie du dispositif à oscillateur.

Ce mode de réalisation est applicable dans le cas du système 16 de communication décrit ultérieurement, notamment dans le cas de la synchronisation de la fréquence de l'oscillateur avec une source de référence distante.

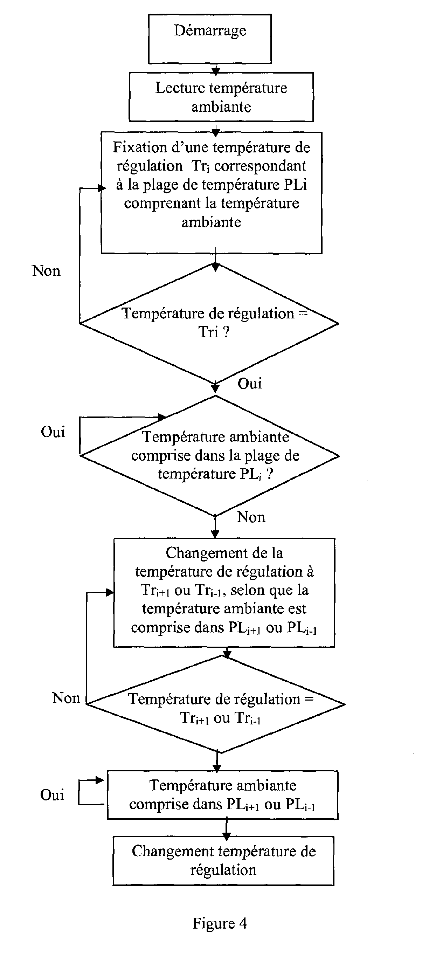

Un mode de réalisation d'un algorithme de contrôle de la température de régulation par le processeur est illustré en Figure 4. Cet algorithme peut être implémenté sous la forme d'un programme d'ordinateur stocké dans une mémoire du processeur 4.

Initialement, le procédé de contrôle est démarré. Ceci peut résulter de l'allumage du dispositif 2 à oscillateur, ou du système électronique comportant ce dispositif 2, ou d'une commande d'allumage par un utilisateur.

Le processeur 4 détermine la température ambiante. Ceci peut par exemple se faire par mesure via un senseur 15 de température du dispositif 2, qui mesure la température de la zone où la pièce dans laquelle se trouve le dispositif 2. Alternativement, il s'agit d'un senseur de température externe, apte à communiquer avec le dispositif 2 pour lui transmettre la mesure de la température ambiante.

Toutefois, le senseur 15 de température est optionnel. La mesure de la température ambiante au démarrage peut se faire à l'aide d'un senseur de température 5 servant à la régulation de la température de l'oscillateur. Ce senseur 5 de température est disposé à proximité des moyens 3 de chauffage ou de l'oscillateur 1.

En effet, au démarrage, les différents composants ne sont pas échauffés et leur température correspond à la température ambiante externe du système électronique comprenant cet oscillateur.

Le processeur envoie alors une commande aux moyens de chauffage, pour qu'ils établissent une température de régulation Trᵢ, correspondant à la plage de température PLᵢ dans laquelle la température ambiante mesurée se trouve.

Le processeur vérifie que la température de régulation imposée par les moyens de chauffage a atteint la température de régulation désirée. Ceci peut par exemple être effectué par mesure via un second senseur 5 de température, disposée à proximité des moyens 3 de chauffage ou de l'oscillateur 1.

Si ce n'est pas le cas, le processeur revient à l'étape précédente.

Si c'est le cas, le processeur vérifie que la température ambiante mesurée se situe toujours dans la plage de température PLᵢ.

La vérification du processeur est effectuée périodiquement, avec une fréquence qui dépend des applications et des performances désirées.

En l'absence du senseur de température 15, la température ambiante, quand l'oscillateur est régulé en température, peut être obtenue à partir d'une grandeur électrique corrélée à un courant 13 d'alimentation traversant les moyens 3 de chauffage. Il s'agit par exemple d'une tension de contrôle des moyens 3 de chauffage, qui est proportionnelle au courant électrique de chauffage, qui est lui-même proportionnel à l'écart entre la température ambiante et la température de régulation mesurée par le senseur 5. La température ambiante est donc par exemple déduite à partir de la tension de contrôle des moyens de chauffage.

Le rapport entre la tension de contrôle des moyens de chauffage et le courant électrique de chauffage est généralement constant d'une femtocell à l'autre du même type. Le rapport entre le courant de chauffage et l'écart entre la température ambiante et la température de régulation varie également faiblement d'une femtocell à l'autre.

Si la température ambiante mesurée ne se situe plus dans la plage de température PLᵢ, mais dans une plage de température supérieure PLᵢ₊₁ ou inférieure PLᵢ₋₁, la température de régulation Tri fixée par le processeur est changée en Trᵢ₊₁ ou Trᵢ₋₁ selon le cas.

Le procédé reprend alors, avec vérification périodique de la température ambiante, et changement, le cas échéant, de la température de régulation.

Diverses variations peuvent être pratiquées sur les étapes venant d'être décrites.

Les plages de température PLᵢ sont fixées de sorte que le contrôle par le processeur présente un hystérésis, ce qui permet d'améliorer la stabilité du contrôle. Ceci explique pourquoi les plages de température PLᵢ de la Figure 3 se recoupent entre elles.

Les plages de température ambiante PLᵢ doivent être choisies suffisamment larges pour que dans un fonctionnement nominal, les changements de plage ne soient pas trop fréquents. Toutefois, plus ces plages sont larges, plus la consommation en énergie du dispositif augmente.

Les plages de température peuvent également être affinées en fonction de la localisation du dispositif à oscillateur, notamment du pays et/ou du climat, afin de minimiser la fréquence des changements de plages de température.

Dans un mode de réalisation, un oscillateur peu coûteux est intégré dans le dispositif à oscillateur.

Il existe différents oscillateurs disponibles sur le marché, dont la précision et la stabilité en fréquence sont différentes. Ces paramètres conditionnent le coût de l'oscillateur. Ces paramètres dépendent notamment de la qualité du cristal utilisé, des différents composants et/ou des systèmes de régulation et/ou des systèmes de compensation en température.

Un oscillateur peu coûteux présente une dérive maximum en fréquence supérieure à 200 ppb pour une température ambiante subie par l'oscillateur comprise entre 0 et 70°C. Il s'agit par exemple d'une dérive comprise entre 500 et 2000 ppb.

Un oscillateur plus coûteux présente une dérive maximum en fréquence inférieure à 200 ppb pour une température ambiante subie par l'oscillateur comprise entre 0 et 70°C.

Dans un mode de réalisation, la fréquence d'horloge de l'oscillateur présente une dérive supérieure à 200 ppb pour une température ambiante comprise entre 0 et 70°C.

Toutefois, grâce à la régulation mise en oeuvre par le dispositif à oscillateur et les moyens de chauffage, l'oscillateur fournit une fréquence d'horloge avec une dérive inférieure à 200 ppb pour une variation de 2°C de la température de régulation.

Dans certains cas, le dispositif à oscillateur est intégré dans un système de communication disposé en intérieur (maison, entreprise). La température de régulation ne varie donc pas beaucoup lors de la journée, ce qui implique que les performances de l'oscillateur sont proches de celles d'un oscillateur plus coûteux, grâce au procédé de régulation de la température mis en oeuvre par le dispositif à oscillateur.

Si la température varie brusquement, certains systèmes de communication prévoient des moyens de synchronisation avec une source de référence distance, comme explicité par la suite, qui permet de limiter la dérive de l'oscillateur lors de changements de température de régulation.

Le dispositif 2 à oscillateur peut être utilisé dans divers systèmes électroniques.

Dans un mode de réalisation, le dispositif 2 est intégré dans un système 16 de communication.

Le système 16 de communication comprend un dispositif 2 à oscillateur tel que décrit précédemment, ledit dispositif comprenant donc un oscillateur. Les différents modes de réalisation du dispositif 2 à oscillateur et des procédés de contrôle en température s'appliquent ici.

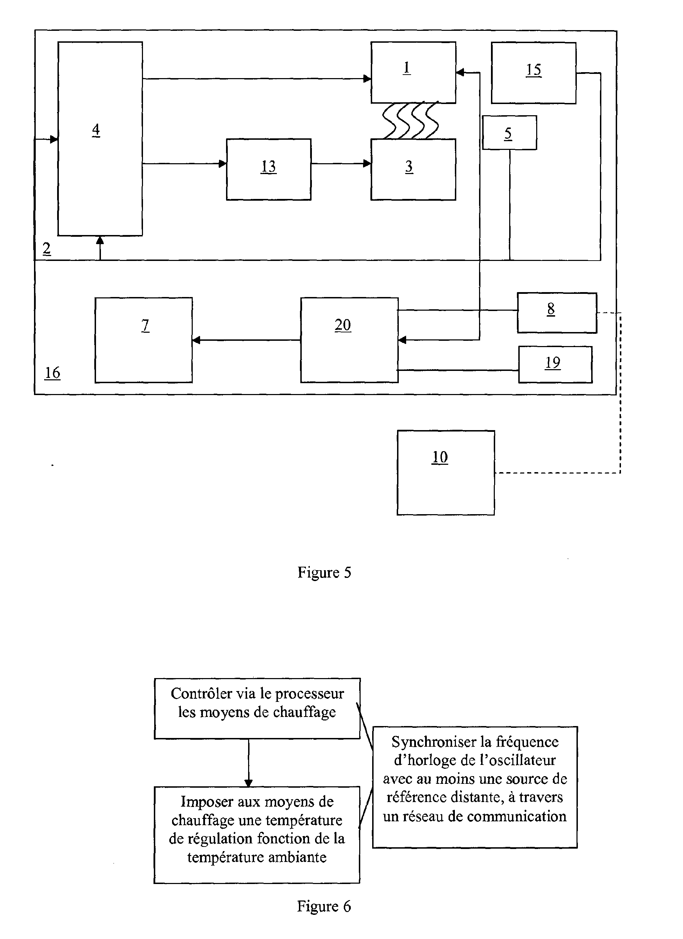

Un mode de réalisation d'un système 16 est illustré en Figure 5.

Dans un mode de réalisation, le dispositif 2 à oscillateur est directement réalisé sur la carte électronique du système 16 à oscillateur. Il s'agit par exemple d'une carte électronique de type PCB (« *printed circuit board* »). Ceci permet de simplifier la construction du système 16 de communication et de réduire son coût, en limitant le nombre de composants.

Le système 16 de communication comprend également un processeur 20 gérant les différentes fonctions et tâches du système 16 de communication. Il est à noter que le processeur 4 du dispositif 2 à oscillateur peut être intégré directement dans le processeur 20 du système de communication, ou constituer une unité de traitement à part.

Le processeur 20 peut comprendre une mémoire et est apte à stocker des programmes et à en exécuter le contenu.

Le système 16 de communication comprend en outre un module 7 de communication radio, dont un signal horloge de référence est généré sur la base de la fréquence d'horloge générée par l'oscillateur 1.

Le module 7 peut donc communiquer par ondes radio avec des dispositifs électroniques comme des téléphones portables.

Dans un mode de réalisation, le système de communication est une femtocell, comprenant en outre des moyens 19 de connexion à un réseau Internet, comme par exemple une femtocell avec interface Ethernet selon la norme internationale IEEE 802.1. Dans un mode de réalisation, la femtocell est associée à une passerelle permettant la connexion à Internet (« *Residential Gateway* »), comme par exemple un modem ADSL.

Dans le cas d'une femtocell, le module 7 de communication radio est configuré pour communiquer avec des téléphones mobiles cellulaires.

D'autre part, les moyens 19 de connexion à un réseau Internet permettent d'acheminer les données (voix, images, etc.) vers un réseau de téléphonie mobile, en passant par un réseau Internet (comme par exemple un réseau IP, *Internet Protocol* en anglais).

Le module 7 de communication radio nécessite un signal horloge de référence, qui est ensuite multiplié pour obtenir la fréquence radio. Comme énoncé précédemment, le signal horloge de référence est généré par l'oscillateur 1 du dispositif 2 à oscillateur.

Par exemple, dans le cas d'une femtocell, le signal horloge de référence présente une fréquence de l'ordre de 20 MHz. Cette horloge doit être très précise. Les dérives tolérables sont ici très faibles. Par exemple, les femtocell fonctionnant selon la norme de troisième génération HSPA (*High Speed Packet Access* en anglais) fonctionnent à une fréquence radio de l'ordre de 2GHz et doivent respecter une dérive inférieure à 250 ppb (*Part Per Billion* en anglais).

Pour assurer une telle stabilité, la stabilité de la fréquence d'horloge de l'oscillateur 1 doit respecter également ces contraintes. A cet effet, le système de communication comprend des moyens 8 de synchronisation, pour synchroniser la fréquence d'horloge de l'oscillateur 1 avec une fréquence de référence fournie par au moins une source 10 de référence distante, à travers un réseau de communication.

Les moyens 8 de synchronisation peuvent, par exemple, utiliser une connexion à des horloges de référence disponibles au travers du réseau Internet à l'aide du protocole NTP (*Network Time Protocol* en anglais défini par la RFC 1305) ou encore le protocole PTP (*Précision Time Protocol* en anglais) normalisé par l'IEEE sous la référence IEEE 1588 et standardisé sous la référence IEC 61588.

Les moyens 8 de synchronisation comparent, éventuellement par l'intermédiaire ou sur ordre d'un processeur 4, 20 du système de communication, la fréquence d'horloge de l'oscillateur 1 avec la fréquence de référence fournie par la source 10, et corrige, le cas échéant, la dérive de l'oscillateur 1.

Ces moyens 8 de synchronisation peuvent se présenter sous la forme d'un processeur apte à communiquer avec l'extérieur.

On a représenté en Figure 6 un procédé de contrôle dans un système 16 de communication, permettant d'assurer le contrôle en température de l'oscillateur ainsi qu'une synchronisation de sa fréquence d'horloge.

La synchronisation de la fréquence d'horloge et le contrôle en température de l'oscillateur sont directement liés, dans la mesure où la variation en température de l'oscillateur a un impact critique sur la stabilité et la précision de sa fréquence d'horloge.

Le processeur 4 (ou le processeur 20, dans le cas où le processeur 4 et le processeur 20 constituent une même unité de traitement) contrôle les moyens 3 de chauffage de sorte que les moyens 3 de chauffage imposent une température de régulation à l'oscillateur 1, ladite température de régulation étant fonction de la température ambiante, et étant destinée à assurer une stabilisation de la génération en fréquence par l'oscillateur 1.

En outre, les moyens 8 de synchronisation synchronisent la fréquence d'horloge de l'oscillateur avec une fréquence de référence fournie par au moins une source 10 de référence distante, au travers d'un réseau de communication, ladite synchronisation étant réalisée à une fréquence de synchronisation, ladite fréquence de synchronisation étant variable en fonction des variations de la température de régulation.

Dans un mode de réalisation, les moyens de synchronisation reçoivent une information de la part du processeur indiquant que la température de régulation doit être changée, ce qui permet aux moyens de synchronisation d'anticiper les besoins en synchronisation de l'oscillateur, et réduit les risques de dérive.

En effet, plus le processeur 4 fait varier la température de régulation, plus la fréquence d'horloge de l'oscillateur est susceptible d'être modifiée, car l'oscillateur est sensible aux variations de température. Dans ce cas, la fréquence de synchronisation est plus élevée.

A contrario, lorsque la température de régulation est stable, ce qui résulte par exemple du fait que la température ambiante reste stable dans une plage de température PLᵢ, moins les moyens de synchronisation ont besoin de synchroniser la fréquence d'horloge de l'oscillateur avec une source de référence.

Plus particulièrement, la fréquence de synchronisation est fonction de la dérive entre la fréquence d'horloge et la fréquence de la source de référence distante.

Comme déjà décrit pour le dispositif 2, dans un mode de réalisation, le processeur 4 choisit une température de régulation parmi une pluralité de températures constantes prédéterminées, chacune de ces températures constantes étant associée à une plage (PLᵢ) de valeurs de température ambiante prédéterminée.

Par exemple, les plages de valeurs de température sont celles décrites en Figure 3.

Avec ces valeurs, l'écart maximal entre la température ambiante et la température de régulation est réduit à 45°C.

Ceci est avantageux, notamment par rapport à certains systèmes existants de type femtocell dans lequel la température de régulation est fixée à 65°C, pour toute la gamme de température ambiante de -5°C à 45°C, l'écart maximal de température étant alors égal à 70°C.

A titre d'exemple non limitatif, dans le cas d'une femtocell « résidentielle » (c'est-à-dire utilisée dans un cadre privé) comprenant un dispositif à oscillateur fonctionnant avec une seule température de régulation, la consommation maximale des moyens de chauffage sur l'accès 220V est à environ 1.6W. Avec les valeurs de la Figure 3, la consommation maximale sur l'accès 220V est réduite à environ 0.5W (gain de 1.1W).

Ainsi, pour une température ambiante de 25°C, la consommation typique des moyens 3 de chauffage avec les plages de température de la Figure 3 peut-être estimée à 0.25W sur l'accès 220V.

A titre de comparaison, la puissance maximum totale consommée par une femtocell résidentielle est de 9W sur l'accès 220V et la consommation typique totale est de 5,5W à 25°C de température ambiante.

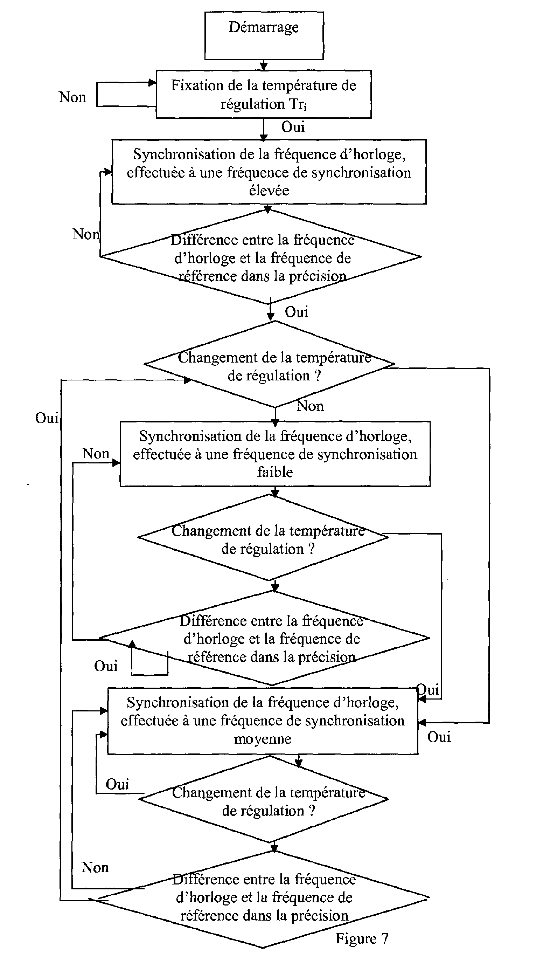

On représente en Figure 7 un mode de réalisation d'un procédé de contrôle dans un système 16 de communication, par exemple de type femtocell, permettant de contrôler la température de l'oscillateur et la synchronisation de la fréquence d'horloge de l'oscillateur.

Au démarrage, le processeur 4 (ou le processeur 20 si les deux processeurs forment une même unité de traitement) détermine la température ambiante.

La température ambiante est par exemple déterminée par mesure par le senseur 15 de température. La mesure de la température ambiante au démarrage peut également se faire à l'aide du senseur de température 5 servant à la régulation de la température de l'oscillateur En effet, au démarrage, les différents composants ne sont pas échauffés et leur température correspond à la température ambiante externe du système électronique comprenant cet oscillateur.

Par la suite, une fois que le procédé de régulation de la température de l'oscillateur a commencé (dans un mode de réalisation, environ 2 minutes après le démarrage), la température ambiante peut être déterminée à partir d'une grandeur électrique corrélée à un courant 13 d'alimentation traversant les moyens 3 de chauffage. Il s'agit par exemple de la tension de contrôle des moyens 3 de chauffage, qui est proportionnelle au courant électrique de chauffage, qui est lui-même proportionnel à l'écart entre la température ambiante et la température de régulation mesurée par le senseur 5. La température ambiante est donc par exemple déduite à partir de la tension de contrôle des moyens de chauffage.

Le rapport entre la tension de contrôle des moyens de chauffage et le courant électrique de chauffage est généralement constant dans des systèmes de communication du même type. Le rapport entre le courant de chauffage et l'écart entre la température ambiante et la température de régulation varie également faiblement d'une femtocell à l'autre.

Comme déjà explicité, le processeur 4 fixe alors une température de régulation Trᵢ fonction de la température ambiante. Par exemple, il s'agit de la loi de paliers décrite en Figure 3, c'est-à-dire qu'il existe une température de régulation Trᵢ pour chaque plage de température ambiante PLᵢ.

Alternativement, comme déjà décrit, il s'agit d'une plage de température dont les deux bornes sont décalées pour réduire l'écart entre la température ambiante mesurée et le centre de cette plage, la température de régulation étant fonction de cette plage de température,

Aux instants où l'oscillateur 1 subit une variation de la température de régulation, sa fréquence d'horloge subit des variations plus élevées que lorsque la température de régulation est fixe.

A titre d'exemple, une variation de 1°C de la température de régulation peut provoquer une variation de la fréquence des oscillateurs généralement utilisés de 100ppb. Quand la température de régulation est fixe, la variation de la fréquence de l'oscillateur est liée à d'autres facteurs, et en particulier le vieillissement (« *aging* ») de l'oscillateur, qui est typiquement inférieur à 20ppb par jour.

Par conséquent, les moyens 8 de synchronisation doivent accéder à la source 10 de référence distante à une fréquence de synchronisation plus élevée, afin de compenser les variations en température subies par l'oscillateur. A titre d'exemple non limitatif, il s'agit d'un accès toutes les 15 secondes avec un échange de 200 octets par accès. Les moyens 8 de synchronisation synchronisent donc la fréquence d'horloge de l'oscillateur avec la fréquence de référence fournie par la source 10 de référence distante.

En général, les moyens 8 de synchronisation synchronisent la fréquence d'horloge de l'oscillateur avec la source 10 de référence distante, lorsque la température de régulation est modifiée par le processeur 4, ou dès lors qu'ils reçoivent une information indiquant que le processeur 4 est prêt à modifier la température de régulation. L'envoi de cette information permet d'anticiper les variations de la température de régulation.

Le processeur 20 (ou processeur 4) compare alors la fréquence d'horloge de l'oscillateur avec la fréquence de référence fournie par la source 10 de référence distante, jusqu'à ce que la différence entre ces fréquences atteigne la précision souhaitée (par exemple ± 250 ppb, ou ± 100 ppb). En général, la précision visée dans cette étape est inférieure à la précision finale maximale souhaitée, en raison de possibles dérives entre deux synchronisations. A titre d'exemple, pour une précision finale maximale de +/- 250ppb, il est visée lors de la synchronisation une précision de +/-100ppb ou +/- 50ppb, afin d'absorber les dérives entre deux synchronisations.

Si le processeur 20 constate que la température de régulation n'est pas modifiée par le dispositif à oscillateur, par exemple, dans le cas où la température ambiante est stable dans un palier de température PLᵢ, les moyens 8 de synchronisation sont commandés pour accéder à la source 10 de référence distante à une fréquence de synchronisation plus faible, voire nulle. Dans un mode de réalisation, il s'agit d'un accès toutes les deux minutes, avec un échange de 200 octets par accès.

Après chaque synchronisation, le processeur 20 (ou processeur 4) compare la fréquence d'horloge de l'oscillateur 1 avec la fréquence de référence fournie par la source 10 de référence distante, jusqu'à ce que la différence entre ces fréquences atteigne la précision souhaitée (par exemple ± 250 ppb). Comme énoncé précédemment, la précision visée à cette étape est choisie comme plus faible que la précision finale souhaitée, pour compenser de possibles dérives entre deux synchronisations.

Hormis au démarrage du procédé, lorsque la température de régulation Trᵢ est modifiée par le processeur 4, les moyens de synchronisation accèdent à la source 10 de référence distante à une fréquence de synchronisation moyenne (par exemple un accès toutes les 15 secondes, avec un échange de 200 octets par accès), afin de compenser les variations en température subies par l'oscillateur. Les moyens 8 de synchronisation synchronisent donc la fréquence d'horloge de l'oscillateur avec la fréquence de référence fournie par la source 10 de référence distante.

Comme à chaque synchronisation, le processeur 20 compare la fréquence d'horloge de l'oscillateur avec la fréquence de référence fournie par la source 10 de référence distante, jusqu'à ce que la différence entre ces fréquences atteigne la précision souhaitée (par exemple ± 250 ppb). Comme énoncé précédemment, la précision visée à cette étape est choisie comme plus faible que la précision finale souhaitée, pour compenser de possibles dérives entre deux synchronisations.

Il est à noter que le changement de la température de régulation est plus brusque au démarrage qu'au cours du fonctionnement du dispositif à oscillateur, ce qui explique que la fréquence de synchronisation soit plus élevée au démarrage qu'au cours du fonctionnement du dispositif à oscillateur.

Ainsi, la variation en fréquence de l'oscillateur au démarrage peut atteindre plusieurs centaines de ppb/mn, ce qui nécessite une fréquence de synchronisation, pour accès à la source 10 de référence, élevée. Dans un mode de réalisation, il s'agit d'un accès chaque seconde avec un échange de 200 octets par accès.

Avec les plages, non limitatives, de température ambiante de la Figure 3, les changements de plage sont en général peu fréquents (environ une fois par jour) avec une durée d'environ 15mn.

Dans un mode de réalisation, un oscillateur peu coûteux est intégré dans le système de communication, comme par exemple un système de communication de type femtocell.

La fréquence d'horloge de l'oscillateur présente une dérive supérieure à 200 ppb pour une température ambiante comprise entre 0 et 70°C.

Toutefois, grâce à la régulation mise en oeuvre par le dispositif à oscillateur et les moyens de chauffage, l'oscillateur fournit une fréquence d'horloge avec une dérive inférieure à 200 ppb pour une variation de 2°C de la température de régulation.

Etant donné que pour certains systèmes de communication (comme les femtocells d'intérieur), les changements de plage sont peu fréquents, on obtient des performances voisines de systèmes de communication comprenant des oscillateurs plus coûteux.

La solution proposée n'entraîne pas d'accroissement significatif de la fréquence moyenne de synchronisation par rapport à des systèmes existants.

Dans un exemple de réalisation, la température ambiante varie avec un taux inférieur à 0.5°C/mn, la vitesse maximale de la variation de la fréquence d'horloge étant alors inférieure à 50 ppb/mn. Dans ce cas, la fréquence de synchronisation, pour accès à la source 10 de référence, est moyenne (par exemple un accès toutes les 15 secondes avec un échange de 200 octets par accès).

Dans un mode de réalisation, les moyens 8 de synchronisation reçoivent une information de la part du processeur indiquant que la température de régulation doit être changée, ce qui permet aux moyens de synchronisation d'anticiper les besoins en synchronisation de l'oscillateur, et réduit les risques de dérive.

Dans ce cas, le processeur enjoint les moyens de synchronisation de se connecter au serveur distant à une fréquence de synchronisation moyenne (par exemple un accès toutes les 15 secondes avec un échange de 200 octets par accès).

Dans un exemple de réalisation, lorsque la température ambiante reste dans une plage PLᵢ large de 17°C, la température de l'oscillateur peut être régulée avec une précision meilleure que 0.6°C et la variation maximale de la fréquence d'horloge de l'oscillateur en température peut alors être inférieure à 90 ppb, ne nécessitant donc pas un accès à la source 10 de référence distante.

Dans ce cas, les accès à la source 10 de référence distante sont provoqués par le vieillissement des composants (typiquement 20 ppb par jour) ou par un changement de plage de température ambiante.

Comme on le comprend, la solution proposée présente de nombreux avantages.

D'une part, le dispositif à oscillateur est peu coûteux. En particulier, le dispositif à oscillateur peut être intégré dans un système de communication, et assurer de bonnes performances en termes de stabilité et précision de la fréquence d'horloge de l'oscillateur, même avec un oscillateur présentant, à lui seul, une stabilité en fréquence plus faible que certains oscillateurs disponibles sur le marché. Ces oscillateurs sont moins coûteux que d'autres oscillateurs disponibles sur le marché, notamment en raison de la qualité inférieure du cristal utilisé.

Le dispositif à oscillateur, via le contrôle innovant en température de la stabilité en fréquence, assure malgré tout de bonnes performances, comparables à des oscillateurs plus coûteux. En outre, le dispositif à oscillateur peut être directement intégré dans le circuit imprimé du système de communication, ce qui réduit le nombre de composants et les coûts associés.

D'autre part, ce dispositif présente l'avantage de réduire la consommation électrique nécessaire à la régulation en température de l'oscillateur, et ce notamment à température ambiante basse ou moyenne. La régulation en température de l'oscillateur dépend de la température ambiante, ce qui permet une régulation plus fine et mieux adaptée, et par conséquent une réduction de la consommation électrique.

Ainsi, le dispositif permet une réduction de la taille et de la puissance des moyens électriques alimentant un système de communication équipé d'un oscillateur, comme par exemple une femtocell. Un tel système de communication est donc plus économique.

Un autre avantage est de conserver de bonnes performances en termes de stabilité et précision de la fréquence d'horloge de l'oscillateur, malgré la réduction de la consommation électrique. En particulier, la fréquence de synchronisation, correspondant à la fréquence à laquelle les moyens de synchronisation doivent accéder à la source de référence pour synchroniser la fréquence d'horloge de l'oscillateur, ne nécessite pas d'être augmentée malgré ces gains en énergie et en consommation.

La solution proposée s'applique à divers systèmes de communication intégrant un oscillateur. Par exemple, mais non limitativement, elle s'applique à un VCTCXO (« *Voltage Controlled, Temperature Compensated Crystal Oscillators* »).

## Revendications

1. Système (16) de communication, comprenant :
- un oscillateur (1), pour la génération d'une fréquence d'horloge,
- des moyens (3) de chauffage de l'oscillateur (1),
- un processeur (4), adapté pour contrôler les moyens (3) de chauffage de sorte que les moyens (3) de chauffage imposent une température de régulation à l'oscillateur (1), ladite température de régulation étant fonction de la température ambiante.
- un module (7) de communication radio, dont un signal horloge de référence est généré sur la base de la fréquence d'horloge générée par l'oscillateur (1), et
- des moyens (8) de synchronisation, configurés pour synchroniser la fréquence d'horloge de l'oscillateur (1) avec une fréquence de référence fournie par au moins une source (10) de référence distante, à travers un réseau de communication, ladite synchronisation étant réalisée à une fréquence de synchronisation variable en fonction des variations de la température de régulation.

2. Système selon la revendication 1, dans lequel l'oscillateur (1) est apte à générer une fréquence d'horloge qui est fonction d'une tension appliquée audit oscillateur (1).

3. Système selon l'une des revendications 1 ou 2, dans lequel le processeur (4) est programmé pour stocker une pluralité de plages (PLᵢ) de valeurs de température ambiante, à chaque plage de valeur étant associée une valeur de température (Trᵢ) de régulation.

4. Système selon l'une des revendications 1 à 3, dans lequel la fréquence d'horloge de l'oscillateur présente une dérive supérieure à 200 ppb pour une température ambiante comprise entre 0 et 70°C, et une dérive inférieure à 200 ppb pour une variation de 2°C de la température ambiante.

5. Système selon l'une des revendications 1 à 4, comprenant en outre des moyens (19) de connexion à un réseau Internet.

6. Procédé de contrôle d'un système de communication selon l'une des revendications 1 à 5, **caractérisé en ce qu'il** comprend les étapes selon lesquelles :
- le processeur (4) contrôle les moyens (3) de chauffage de sorte que les moyens (3) de chauffage imposent une température de régulation à l'oscillateur (1), ladite température de régulation étant fonction de la température ambiante,
- les moyens (8) de synchronisation synchronisent la fréquence d'horloge de l'oscillateur avec une fréquence de référence fournie par au moins une source (10) de référence distante, au travers d'un réseau de communication, ladite synchronisation étant réalisée à une fréquence de synchronisation, ladite fréquence de synchronisation étant variable en fonction des variations de la température de régulation.

7. Procédé selon la revendication 6, dans lequel le processeur (4) fait varier la température de régulation en fonction de la température ambiante, la température de régulation variant dans le sens d'une réduction de l'écart entre la température ambiante et la température de régulation, permettant ainsi de réduire la consommation en énergie du dispositif à oscillateur.

8. Procédé selon l'une des revendications 6 ou 7, dans lequel le processeur (4) choisit une température de régulation (Trᵢ) parmi une pluralité de températures constantes prédéterminées, chacune de ces températures constantes étant associée à une plage (PLᵢ) de valeurs de température ambiante prédéterminée.

9. Procédé selon l'une des revendications 6 à 8, dans lequel le processeur (4) :
- détermine une plage de température ambiante initiale, fonction de la température ambiante mesurée initialement,
- décale les deux bornes de cette plage de température pour réduire l'écart entre la température ambiante mesurée et le centre de cette plage, la température de régulation étant fonction de cette plage de température, et
- recalcule cette plage lorsque la température ambiante atteint une borne de cette plage de température.

10. Procédé selon l'une des revendications 6 à 9, dans lequel les moyens de synchronisation synchronisent la fréquence d'horloge de l'oscillateur avec au moins une source (10) de référence distante,
- lorsque la température de régulation est modifiée par le processeur (4), ou
- dès lors qu'ils reçoivent une information indiquant que le processeur (4) est prêt à modifier la température de régulation,
cette synchronisation étant réalisée à une fréquence de synchronisation fonction de la dérive entre la fréquence d'horloge de l'oscillateur (1) et la fréquence de référence de la source (10) de référence distante.

11. Procédé selon l'une des revendications 6 à 10, dans lequel la température ambiante est:
- au démarrage du procédé de contrôle, mesurée par l'intermédiaire d'un senseur (5) de température du dispositif (2) à oscillateur, puis,
- déduite de la mesure d'une grandeur électrique corrélée à un courant (13) d'alimentation traversant les moyens (3) de chauffage.

## Patentansprüche

1. Kommunikationssystem (1), umfassend:
- einen Oszillator (1) zum Generieren einer Taktfrequenz,
- Mittel (3) zum Erwärmen des Oszillators (1),
- einen Prozessor (4), der geeignet ist, um die Erwärmungsmittel (3) so zu steuern, dass die Erwärmungsmittel (3) dem Oszillator (1) eine Regeltemperatur vorgeben, wobei die Regeltemperatur von der Umgebungstemperatur abhängig ist,
- ein Funkkommunikationsmodul (7), dessen Referenztaktsignal auf der Basis der Taktfrequenz, die durch den Oszillator (1) generiert wird, generiert wird,
- Synchronisierungsmittel (8), die ausgelegt sind, um die Taktfrequenz des Oszillators (1) mit einer Referenzfrequenz zu synchronisieren, die durch mindestens eine beabstandete Referenzquelle (10) bereitgestellt wird, über ein Kommunikationsnetz, wobei die Synchronisierung auf einer Synchronisierungsfrequenz erfolgt, die in Abhängigkeit von den Veränderungen der Regeltemperatur veränderlich ist.

2. System nach Anspruch 1, wobei der Oszillator (1) geeignet ist, eine Taktfrequenz zu generieren, die von einer an den Oszillator (1) angelegten Spannung abhängig ist.

3. System nach einem der Ansprüche 1 oder 2, wobei der Prozessor (4) programmiert ist, um eine Vielzahl von Bereichen (PLᵢ) von Werten der Umgebungstemperatur zu speichern, wobei jedem Wertebereich ein Regeltemperaturwert (Trᵢ) zugeordnet ist.

4. System nach einem der Ansprüche 1 bis 3, wobei die Taktfrequenz des Oszillators bei einer Umgebungstemperatur zwischen 0 und 70 °C eine Abweichung aufweist, die größer als 200 ppb ist, und bei einer Veränderung von 2 °C der Umgebungstemperatur eine Abweichung aufweist, die kleiner als 200 ppb ist.

5. System nach einem der Ansprüche 1 bis 4, umfassend ferner Mittel (19) zum Verbinden mit einem Internet-Netzwerk.

6. Verfahren zum Steuern eines Kommunikationssystems nach einem der Ansprüche 1 bis 5, **dadurch gekennzeichnet, dass** es die folgenden Schritte umfasst:
- der Prozessor (4) steuert die Erwärmungsmittel (3) so, dass die Erwärmungsmittel (3) dem Oszillator (1) eine Regeltemperatur vorgeben, wobei die Regeltemperatur von der Umgebungstemperatur abhängig ist,
- die Synchronisierungsmittel (8) synchronisieren die Taktfrequenz des Oszillators mit einer Referenzfrequenz, die durch mindestens eine beabstandete Referenzquelle (10) bereitgestellt wird, über ein Kommunikationsnetz, wobei die Synchronisierung auf einer Synchronisierungsfrequenz erfolgt, wobei die Synchronisierungsfrequenz in Abhängigkeit von den Veränderungen der Regeltemperatur veränderlich ist.

7. Verfahren nach Anspruch 6, bei dem der Prozessor (4) bewirkt, dass sich die Regeltemperatur in Abhängigkeit von der Umgebungstemperatur verändert, wobei die Regeltemperatur sich in der Richtung einer Verringerung des Unterschieds zwischen der Umgebungstemperatur und der Regeltemperatur verändert, wodurch der Energieverbrauch der Oszillatorvorrichtung gesenkt werden kann.

8. Verfahren nach einem der Ansprüche 6 oder 7, bei dem der Prozessor (4) eine Regeltemperatur (Trᵢ) aus einer Vielzahl von vorbestimmten konstanten Temperaturen auswählt, wobei jede dieser konstanten Temperaturen einem vorbestimmten Bereich (PLᵢ) von Werten einer Umgebungstemperatur zugeordnet ist.

9. Verfahren nach einem der Ansprüche 6 bis 8, bei dem der Prozessor (4)
- einen anfänglichen Umgebungstemperaturbereich bestimmt, der von der anfänglich gemessenen Umgebungstemperatur abhängt,
- die zwei Grenzwerte dieses Temperaturbereichs versetzt, um den Unterschied zwischen der gemessenen Umgebungstemperatur und der Mitte dieses Bereichs zu verringern, wobei die Regeltemperatur von diesem Temperaturbereich abhängig ist, und
- diesen Bereich neu berechnet, wenn die Umgebungstemperatur einen Grenzwert dieses Temperaturbereichs erreicht.

10. Verfahren nach einem der Ansprüche 6 bis 9, bei dem die Synchronisierungsmittel die Taktfrequenz des Oszillators mit mindestens einer beabstandeten Referenzquelle (10) synchronisieren,
- wenn die Regeltemperatur durch den Prozessor (4) verändert wird, oder
- sobald sie eine Information empfangen, die anzeigt, dass der Prozessor (4) bereit ist, die Regeltemperatur zu verändern,
wobei diese Synchronisierung auf einer Synchronisierungsfrequenz erfolgt, die von der Abweichung zwischen der Taktfrequenz (1) und der Referenzfrequenz der beabstandeten Referenzquelle (10) abhängig ist.

11. Verfahren nach einem der Ansprüche 6 bis 10, bei dem die Umgebungstemperatur:
- beim Starten des Steuerungsverfahrens mittels eines Temperaturfühlers (5) der Oszillatorvorrichtung (2) gemessen wird und dann
- von dem Messwert einer elektrischen Größe abgezogen wird, die mit einem Versorgungsstrom (13), der die Erwärmungsmittel (3) durchfließt, korreliert.

## Claims

1. A communication system (16), comprising:
- an oscillator (1), for generating a clock frequency,
- means (3) for heating the oscillator (1),
- a processor (4), adapted for controlling the heating means (3) so that the heating means (3) impose a regulation temperature to the oscillator (1), said regulation temperature depending on room temperature,
- a radio communication module (7), a reference clock signal of which is generated on the basis of the clock frequency generated by the oscillator (1), and
- synchronization means (8), configured for synchronizing the clock frequency of the oscillator (1) with a reference frequency provided by at least one remote reference source (10), through a communications network, said synchronization being achieved at a variable synchronization frequency depending on the variations of the regulation temperature.

2. The system according to claim 1, wherein the oscillator (1) is capable of generating a clock frequency which depends on a voltage applied to said oscillator (1).

3. The system according to one of claims 1 or 2, wherein the processor (4) is programmed for storing a plurality of ranges (PLᵢ) of room temperature values, with each value range being associated with a regulation temperature (Trᵢ) value.

4. The system according to one of claims 1 to 3, wherein the clock frequency of the oscillator has a drift of more than 200 ppb for a room temperature comprised between 0° and 70°C, and a drift of less than 200 ppb for a room temperature variation of 2°C.

5. The system according to one of claims 1 to 4, further comprising means (19) for connecting to an Internet network.

6. A method for controlling a communication system according to one of claims 1 to 5, **characterized in that** it comprises the steps according to which:
- the processor (4) controls the heating means (3) so that the heating means (3) impose a regulation temperature to the oscillator (1), said regulation temperature depending on room temperature,
- the synchronization means (8) synchronize the clock frequency of the oscillator with a reference frequency provided by at least one remote reference source (10), through a communications network, said synchronization being achieved at a synchronization frequency, said synchronization frequency being variable depending on variations of the regulation temperature.

7. The method according to claim 6, wherein the processor (4) varies the regulation temperature according to the room temperature, the regulation temperature varying in the sense of a reduction of the difference between the room temperature and the regulation temperature, thereby allowing a reduction in the consumption of energy of the oscillator device.

8. The method according to one of claims 6 or 7, wherein the processor (4) selects a regulation temperature (Trᵢ) from among a plurality of predetermined constant temperatures, each of these constant temperatures being associated with a predetermined range (PLᵢ) of room temperature values.

9. The method according to one of claims 6 to 8, wherein the processor (4):
- determines an initial room temperature range, depending on the initially measured room temperature,
- shifts both limits of this temperature range in order to reduce the difference between the measured room temperature and the center of this range, the regulation temperature depending on this temperature range, and
- re-computes this range when the room temperature reaches a limit of this temperature range.

10. The method according to one of claims 6 to 9, wherein the synchronization means synchronize the clock frequency of the oscillator with at least one remote reference source (10),
- when the regulation temperature is modified by the processor (4), or
- as soon as they receive information indicating that the processor (4) is ready for modifying the regulation temperature,
this synchronization being achieved at a synchronization frequency depending on the drift between the clock frequency of the oscillator (1) and the reference frequency of the remote reference source (10).

11. The method according to one of claims 6 to 10, wherein the room temperature:
- is, upon starting the control method, measured via a temperature sensor (5) of the oscillator device (2) and then
- is inferred from the measurement of an electric quantity correlated with a power supply current (13) flowing through the heating means (3).
